# EUROPEAN PATENT APPLICATION

(11) **EP 1 418 590 A1**
(43) Date of publication of application: **12.05.2004**
(21) Application number: 02447211.0
(22) Date of filing: 07.11.2002
(51) Int. Cl.: G11C 11/14, G11C 11/15, G11C 11/16

(54) **Magnetic device**

(71) Applicant: INTERUNIVERSITAIR MICRO-ELEKTRONICA CENTRUM VZW, 3001 Heverlee (BE)
(72) Inventor: Hiebert, Wayne, T4J 1R4 Ponoka AB (CA); De Boeck, Jo, 2861 St. Katelijne Waver (BE); Lagae, Liesbeth, 3020 Herent (BE); Wirix-Speetjens, Roel, 3680 Maaseik (BE)
(74) Representative: Van Malderen, Joelle

(57) **Abstract**

The present invention is related to a method for improving the desirable properties of a magnetic device, as e.g. magnetisation uniformity and reproducibility is disclosed. Moreover the invention provides magnetic cells that are more magnetically homogeneous, with smaller amount of end domain magnetisation canting from the average cell magnetisation direction. The invention can provide a magnetic memory cell with less variation in switching fields, more spatially coherent dynamical magnetic properties for high speed and processional or coherent magnetic switching, and higher signal due to this increased uniformity. It can provide a magnetic sensor with more spatially coherent magnetic properties for high speed and processional or coherent magnetic switching, and increased signal. It can provide a read head element with more spatially coherent magnetic properties for high speed and processional or coherent magnetic sensing, and increased signal.

## Description

### Field of the invention

The present invention is related to the fields of magnetic memories, magnetic sensors (GMR, AMR, or TMR), and magnetic recording heads (read and write). Common to all fields is the basis of a domain wall free operative soft magnetic cell device.

### Background of the invention

GMR (Giant Magneto Resistance) and its descendants have been commercialised in the read head sensor of a magnetic recording head and in various other magnetic sensors. Companies are currently in the development stage to commercialise magnetic random access memory (MRAM) based on TMR (Tunneling Magneto Resistance) effects. Current issues in industry in magnetism are (1) higher speed (magnetisation dynamics), (2) lower size, (3) patterned media, (4) concern over the super paramagnetic limit and others. Most industrial needs require micro structurally patterned thin-film magnetic elements.

Any magnetic sample with boundaries is difficult to magnetise completely right up to the boundaries. In particular, for technologically interesting thin film micro structured elements, closure domains form in the remnant state that partially demagnetise the element. Such remnant states are undesirable for several reasons: they decrease remnant magnetisation (for instance, lowering the maximum signal in a memory cell), they complicate magnetic structure and tend to complicate magnetic behaviour, making study more difficult, and, in particular, they adversely effect the understanding and practice of high-speed magnetisation processes due to their non-uniformity. Increased uniformity of magnetisation, combined with reproducibility, is often desired in both research and device operation.

The shape of an ellipsoid, by its mathematical nature, can mimic magneto static continuity, suppress closure domains, and lead to uniform magnetisation. For extremely small samples, the exchange interaction dominates magnetostatics, and is theorised to be able to lead to uniform magnetisation (and, thus, suppression of closure domains). These are well known ideas in magnetism, available since the 1950s. Recent review books covering these ideas are (1) A. Aharoni, *Introduction to the theory of ferromagnetism, 2*^{*nd*} *Edition,* Oxford University Press, Oxford (2000). (2) A. Hubert and R. Schafer, *Magnetic domains (The analysis of magnetic microstructures),* Springer-Verlag, Berlin Heidelberg (1998).

But real thin film ellipses are not 'exactly' ellipsoids and have been known to have closure domains, such that a uniform magnetisation leading to substantially 1 single magnetic domain haven't been achieved.

Memory cells, spin valve GMR elements, and magnetic sensors currently
(a) Ignore end domains; but end domains reduce GMR signal and increase variability from cell to cell (e.g. switching fields have too much variation amongst cells that are supposed to be identical).
(b) Use a hard bias for GMR read head element to sweep domains out of the element; but a hard bias lowers sensitivity.
(c) Play with cell shape to reduce end domains and/or their effects; but playing with sample shape is difficult and time-consuming for fabrication. Moreover end domains are rarely eliminated.
Various methods to handle end domains exist:
(a) Pin cell ends so that switching is less variable (US patent 5,748,524, 'MRAM with pinned ends', Chen et al.); here some TMR or GMR signal is lost due to the pinned ends not contributing.
(b) Edge closer structure in laminates in recording head yoke (US patent 5,331,728, 'Method of fabricating magnetic thin film structures with edge closure layers', Argyle et al.); which is difficult and time-consuming to produce.

In US patent application US2002/0055190 ('Magnetic memory with structures that prevent disruptions to magnetisation in sense layer', Thomas C. Anthony), a keeper structure providing a flux closure path to direct demagnetisation fields away from the sense layer is disclosed. However, the magnetisation in the keeper and the cell are always perpendicular to each other and no single magnetic domain state is induced in the cell.

### Aim of the invention

It is an aim of the invention to offer an element of control to the degree of magnetisation uniformity and amount of flux-closure suppression in a magnetic cell.

### Sunmary of the invention

The present invention is related to a magnetic device comprising:
- A magnetic cell of a first magnetic material of a first permeability; and
- An immersion layer of a second magnetic material of a second permeability, said immersion layer providing a magnetic flux closure path for the magnetisation field of said magnetic cell,
wherein said immersion layer does not have a predetermined magnetisation direction.

Said first magnetic material may have a higher permeability, a lower permeability or equal permeability than said second magnetic material.
Said magnetic cell may be in direct contact with said immersion layer.

Said immersion layer may be discontinuous and/or comprising different separated subparts.

Said magnetic cell may be attached on top of said immersion layer.

The edges of said magnetic cell may be in direct contact with said immersion layer. In that case, the upper surface of said magnetic cell may extend above the level of the upper surface of said immersion layer, or the upper surface of said magnetic cell may extend below the upper surface of said immersion layer or said upper surface of the cell may be at the same level with the upper surface of said immersion layer.

Said magnetic cell may be at least partially embedded in said immersion layer.

The magnetic device of the invention may comprise between said magnetic cell and said immersion layer a spacer layer comprising a non magnetic material.

Said spacer layer may consist of a conductor material or of an insulator material.

The magnetisation of said magnetic cell may form a single magnetic domain.

According to the invention, the magnetic cell may have a rectangular shape or an elliptical shape.

The thickness of said magnetic cell may be larger or smaller than or equal to the thickness of said immersion layer.

Said magnetic cell may be smaller than said immersion layer. At least one of the in-plane dimensions of said immersion layer may be essentially smaller or of the same size than those of said magnetic cell. Both in-plane dimensions of said immersion layer may be essentially smaller or of the same size than those of said magnetic cell.

The invention is also related to a method for producing a magnetic device, characterised in that it comprises the steps of
- Providing a base layer,
- Depositing a first layer consisting of essentially a magnetic material on said base layer,
- Defining a cell area of said first layer corresponding to the required magnetic cell structure,
- Performing a subtractive etch patterning step on said first layer, except on said cell area, for only part of the thickness of said first layer (3).

Another embodiment of the invention is related to a method for producing a magnetic device, comprising a magnetic cell structure, characterised in that it comprises the steps of
- Providing a base layer,
- depositing a first layer consisting of essentially a first magnetic material on said base layer,
- providing a second layer consisting of essentially a second magnetic material,
- Defining a cell area of said second layer corresponding to the required magnetic cell structure,
- Performing a subtractive etch patterning step on said second layer, except on said cell area, for the full thickness of said second layer.

Between said deposition step of said first layer and said deposition step of said second layer an extra step may be performed of depositing a sacrificial layer (7) consisting essentially of a non magnetic material, and wherein said substractive etch patterning step is performed such that at least part of said sacrificial layer is removed.

Another embodiment of the invention is related to a method for the production of a magnetic device comprising a magnetic cell structure, characterised in that it comprises the steps of:
- Providing a base layer
- Etching one or more trenches in said base layer, each trench corresponding to said magnetic cell structure, said base layer having thus a non-flat topology.
- Depositing a first layer consisting essentially of magnetic material on said base layer with said non-flat topology.

The latter method may comprise an additional step of planarization of said first layer. It may further comprise an additional step of depositing a second layer consisting essentially of a second magnetic material on top of the planarized surface.

Said planarization of said first layer may equally be continued until said base layer is reached, and the method of the invention may further comprise the step of depositing a second layer consisting essentially of a second magnetic material on top of the planarized surface.

Said trenches may have an elliptical shape or a rectangular shape in the in-plane dimension.

Said base layer may be a substrate or a processed substrate.

The invention is equally related to a magnetic memory device comprising:
- a bit line essentially consisting of a conductor material,
- a magnetic device, according to the invention, attached on top of said bit line.

In a magnetic memory device of the invention, the immersion layer of said magnetic device may have the same or a smaller width then said bit line.

Said immersion layer may have the same or a smaller length then said bit line.

The easy axis of said magnetic device may be perpendicular or orthogonal to the long dimension of said bit line. The easy axis of said magnetic device may be at an angle to the long dimension of said bit line.

The invention is equally related to a magnetic memory array device comprising:
- A bit line essentially consisting of a conductor material.
- At least 2 magnetic devices according to the invention, wherein said magnetic devices are attached next to each other on said bit line and wherein said magnetic devices are not touching.

In a magnetic memory array device of the invention, all of said magnetic devices may share the same immersion layer.

In a magnetic memory array device of the invention, the magnetisation direction of all of said magnetic devices may be parallel with the long dimension of said bit line.

A magnetic memory array device according the invention may further comprise between each pair of said magnetic devices an additional magnetic structure, wherein said additional magnetic structure consists essentially of a magnetic material and wherein said additional magnetic structure has a shape such that the magnetisation in it is essentially perpendicular to the long direction of said bit line and essentially parallel to the width direction of said bit line.

The invention is equally related to a magnetic field sensor device comprising:
- A sensor area defined by a sensor layer,
- A soft magnetic flux guide, consisting essentially of a magnetic material with a low permeability, for guiding flux lines to said sensor area, wherein said soft magnetic flux guide is adjacent to said sensor area.
- A magnetic immersion layer consisting essentially of a material of a low permeability.

In a magnetic field sensor device according to the invention, said magnetic immersion layer may contact both said sensor layer and said soft magnetic flux guide.

Alternatively, said magnetic immersion layer may contact said sensor layer or said magnetic immersion layer may contact said soft magnetic flux guide.

Said sensor area may consist of 2 GMR sensor layers in line and said soft magnetic flux guide may extend in 2 areas, said 2 areas being located on either side of said 2 GMR sensor layers in line.

Said magnetic cells may be immersed in a same immersion layer and said magnetic cells may be positioned on a regular lattice configuration.

### Short description of the figures

Fig. 1A shows a plan view of a preferred embodiment of the invention comprising a rectangular shaped thin film magnetic structure embedded in an immersion magnetic layer.

Fig. 1B shows a cross-sectional view of the preferred embodiment of Fig. 1A.

Fig. 1C shows a plan view of a preferred embodiment of the invention comprising an elliptical shaped thin film magnetic structure embedded in an immersion magnetic layer.

Fig. 1D shows a cut away 3D view of the embodiment depicted in Fig. 1C.

Fig. 2A, 2B and 2C illustrate that the magnetic structure can be just touching the immersion layer or can be partially embedded or can be fully embedded in the immersion layer.

Figs. 3A-3B are experimental data support figures for the embodiment depicted in Fig. 1C and Fig. 1D.

Fig. 4A shows some experimental evidence of the maintenance of single domain uniformity in a precessional switching process in an experimentally realised embodiment of the invention.

Fig. 4B shows large nonuniformity in a similar experimental structure of prior art style (with no immersion layer).

Fig. 5A shows an embodiment of the present invention wherein the magnetic structure is positioned acentric with respect to the immersion layer.

Fig. 5B illustrates that the immersion layer can occupy a portion of the plan area that the magnetic structure occupies.

Fig. 5C shows another embodiment, wherein the immersion layer can be discontinuous, for example 2 separate pieces.

Fig. 5D shows an embodiment wherein the immersion layer can be at a single position of the magnetic structure.

Fig. 5E shows that the immersion layer can be at several locations with respect to the magnetic structure.

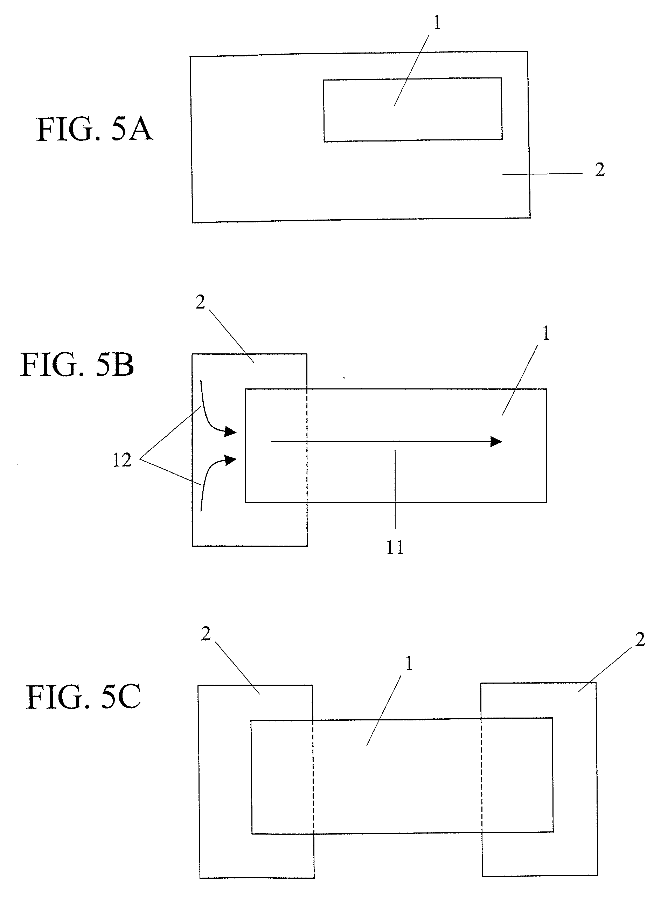

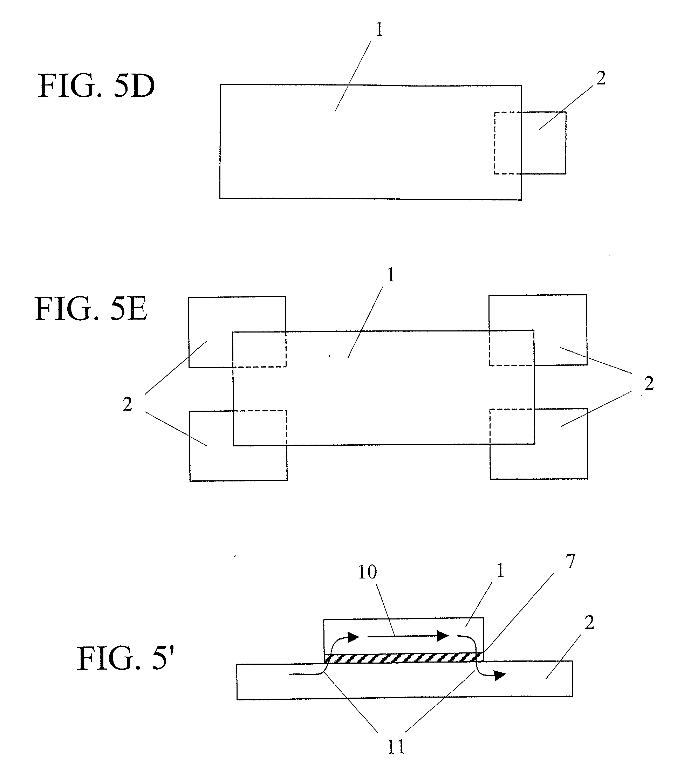

Fig. 5' shows another embodiment wherein the magnetic structure is not touching the immersion layer, but is separated by a spacer layer of nonmagnetic material, either conducting or insulating.

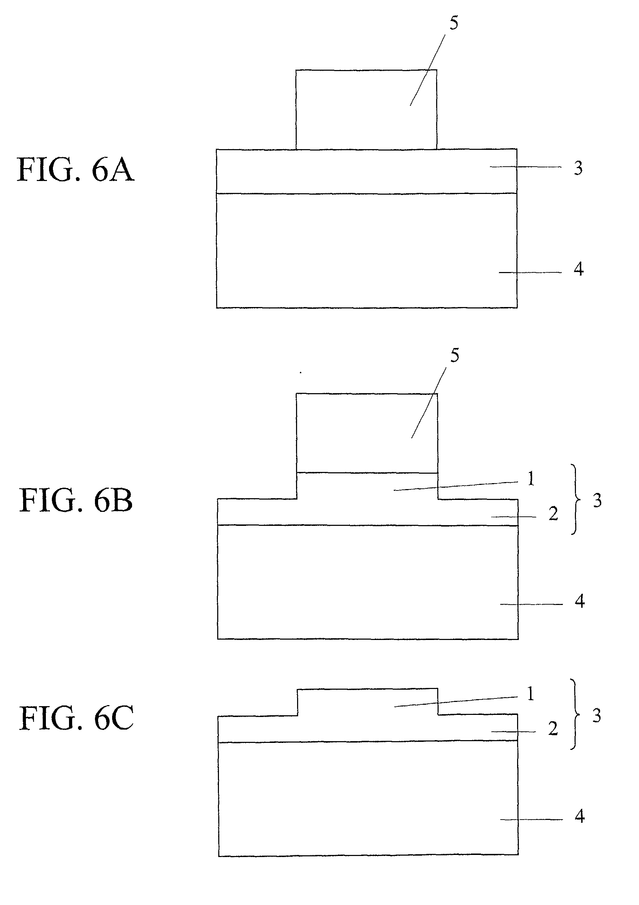

Fig. 6A to 6C show a method for fabrication of devices according to embodiments of the present invention, wherein the magnetic structure and the immersion layer are created out of the same thin film by subtractive etch patterning.

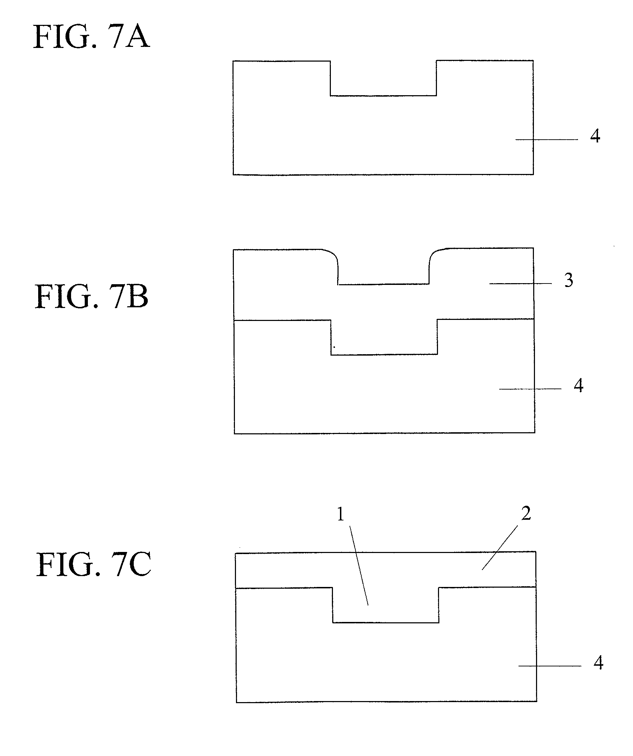

Fig. 7A-7E show another method for the fabrication of devices according to embodiment of the present invention, defined by an inversion process.

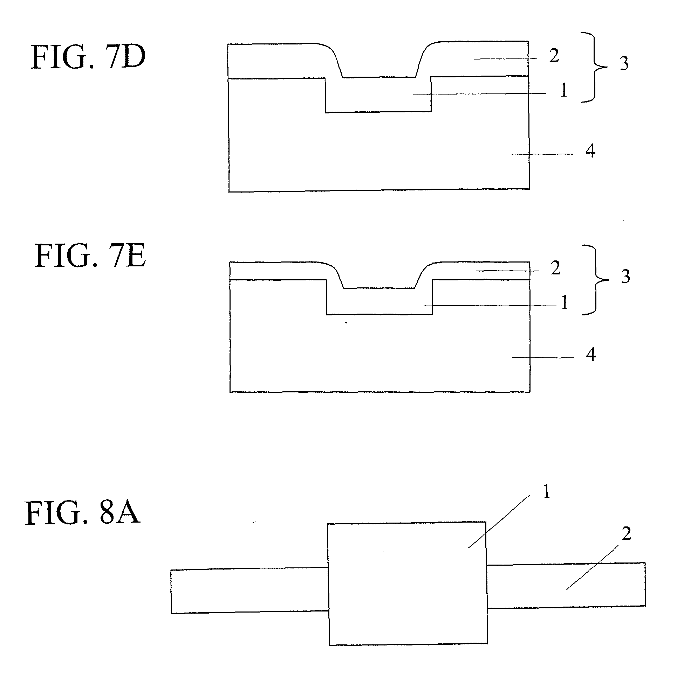

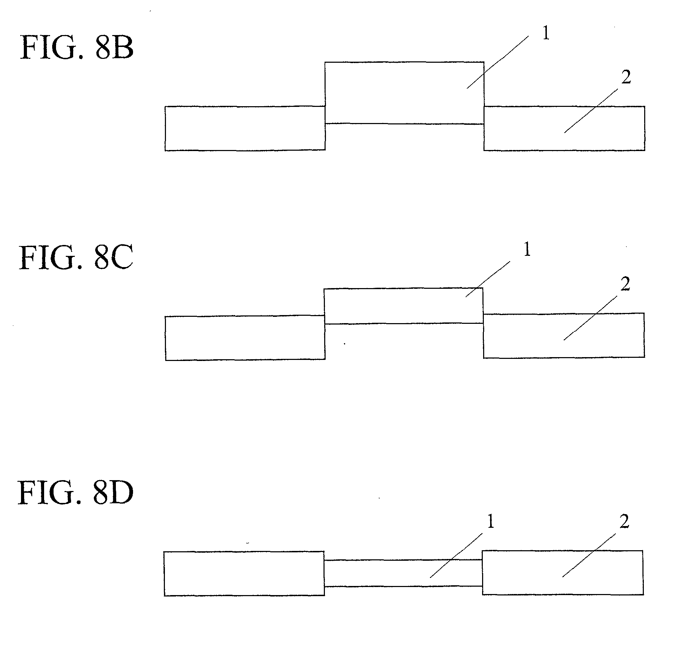

Figs. 8A-8D show alternative embodiments of the invention in cross-section where the film surfaces of the magnetic structure and the immersion layer do not level with each other. Figs. 8A-8D moreover illustrate the possibility of varying the thickness of magnetic structure and immersion layer with respect to each other.

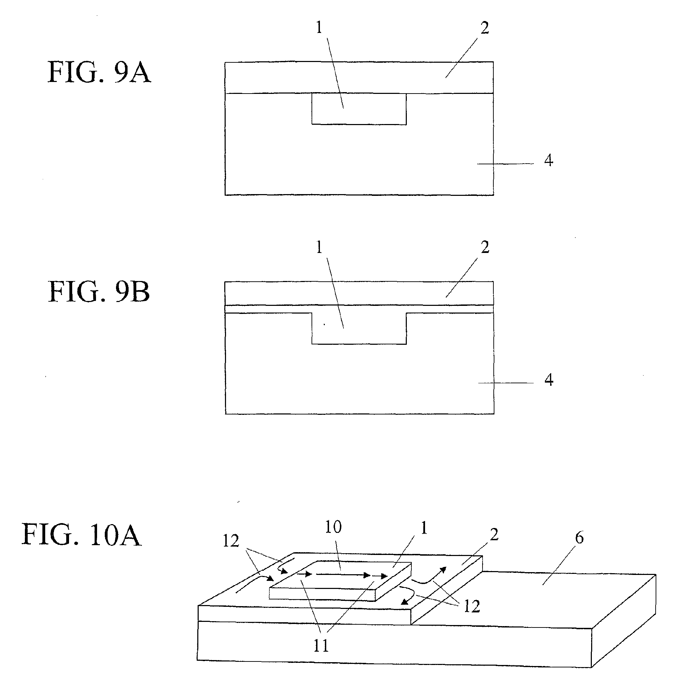

Fig. 9A and 9B illustrate methods for the fabrication of devices according to embodiments of the present invention , using two different materials for magnetic structure and immersion layer.

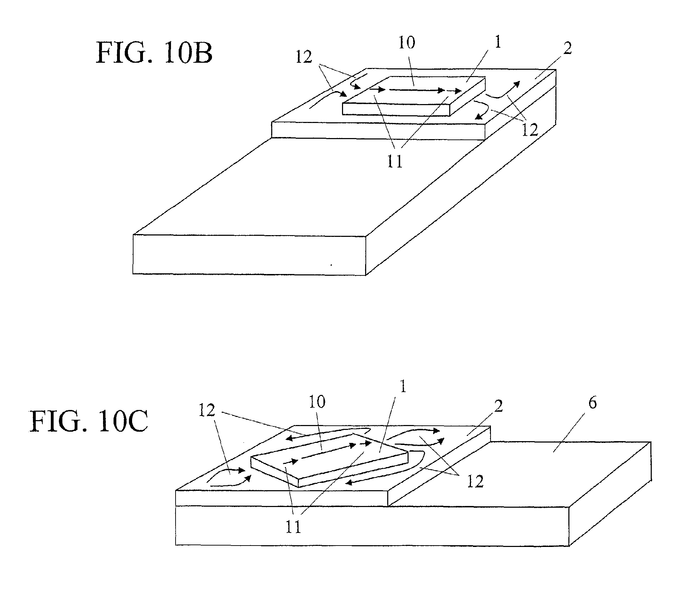

Fig. 10A-C show an embodiment of the invention in a magnetic random access memory (MRAM) cell.

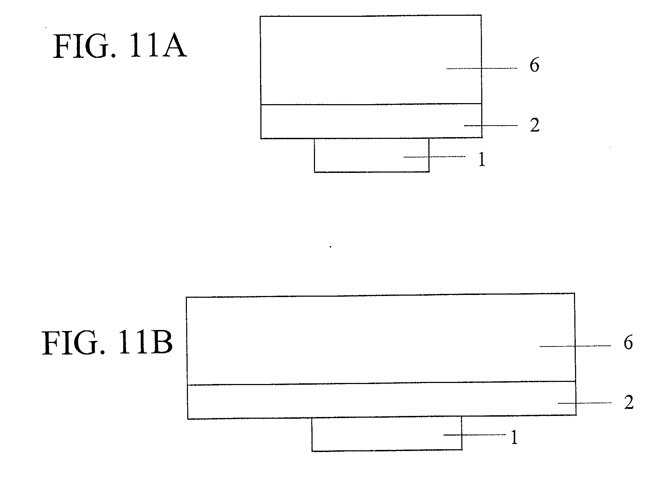

Fig. 11A and Fig. 11B show another embodiment of the present invention for an MRAM device, which has the immersion layer manufactured with the top current line.

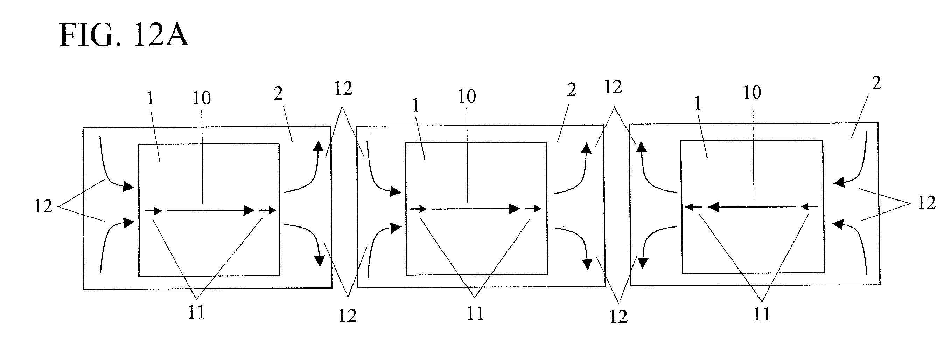

Fig. 12A-D show array embodiments of the present invention, which typically can be used for MRAM devices.

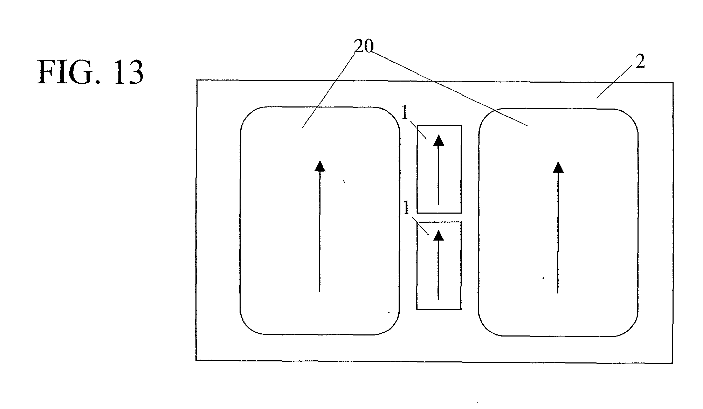

Fig. 13 shows an embodiment of the invention for application in a magnetic field sensor.

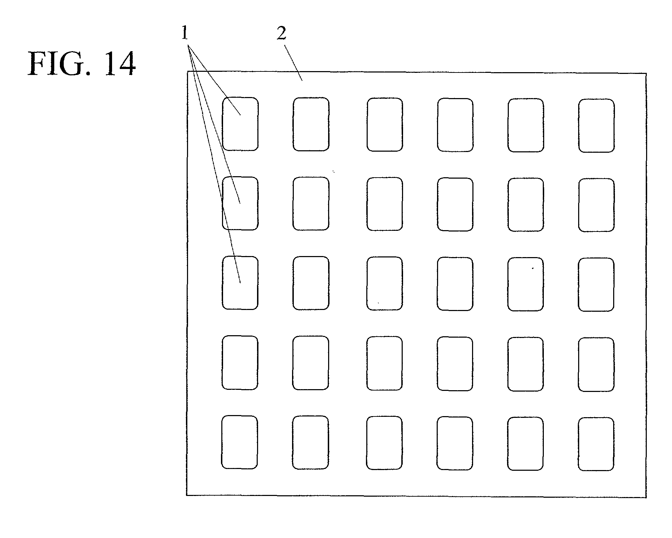

Fig. 14 shows another embodiment of the present invention, namely an array of magnetic cells immersed in a continuous immersion layer.

### Detailed description of the invention

For the purpose of this invention, 'magnetic material' can refer to any magnetic material known in the art, as for instance, but not only, Permalloy (Ni 80%-Fe 20%) or Supermalloy (Ni 80% - Fe 15% - Mo 5% - Mn <1%), or CoFe and CoNiFe alloys of various types.

A method for improving the desirable properties of a magnetic device, as e.g. magnetisation uniformity is disclosed. Moreover the invention provides magnetic cells that are more magnetically homogeneous, with smaller amount of end domain magnetisation canting from the average cell magnetisation direction. The invention can provide a magnetic memory cell with less variation in switching fields, more spatially coherent dynamical magnetic properties for high speed and precessional or coherent magnetic switching, and higher signal due to this increased uniformity. It can provide a magnetic sensor with more spatially coherent magnetic properties for high speed and precessional or coherent magnetic switching, and increased signal. It can provide a read head element with more spatially coherent magnetic properties for high speed and precessional or coherent magnetic sensing, and increased signal.

Disclosed is the combination of a magnetic structure in magnetic contact, for the purposes of magneto static continuity, with an immersion magnetic layer. A thin-film magnetic microstructure is embedded in a continuous thin magnetic film. At the edge of the microstructure, the magnetic flux lines (and magnetisation) can remain perpendicular to the edge by being able to flow out into the immersion magnetic layer. Reduction of the closure domains and increase of the magnetisation homogeneity in the magnetic structure is one benefit of the invention. By choice of materials and spatial size and shape of both structure and layer, and by choice of the physical relationship between the magnetic structure and the immersion magnetic layer, the ability to manipulate and control the level of flux flow between the two, the amount of magnetisation inhomogeneity in magnetic structure, and the amount of flux closure in a given magnetic field is foreseen.

The invention applies to any size and shape of magnetic sample structure. The solution can be applied to very small structures and/or (close-to) perfect ellipsoids to improve their uniformity further.

Increasing the uniformity to the structure edges of a magnetic cell can increase signal considerably, for example, in small MRAM cells, the end domains can take up a substantial portion (30%) of the area of the cell meaning the invention can increase signal (assuming pinned ends) by as much as 30/70 =~ 50% increase.

Next to the aspects of improving the signal and effect on speed due to a single magnetic domain, an aspect of the invention is reproducibility. The invention providing single domain behaviour provides better reproducibility in a very simple way.

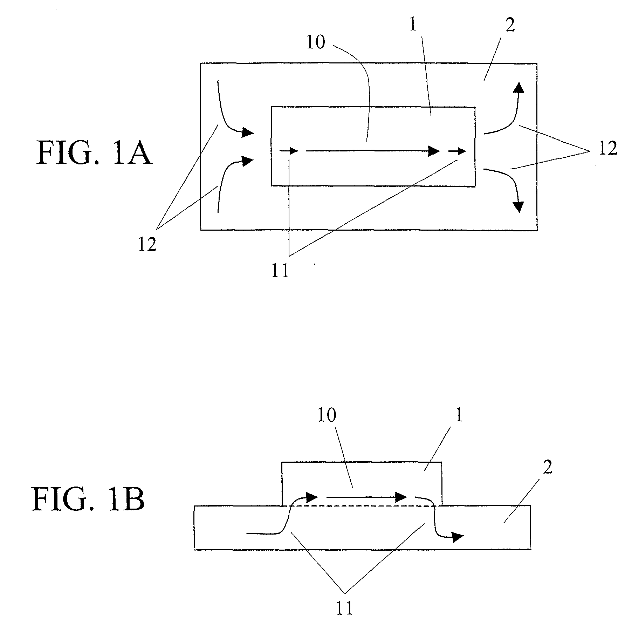

FIG. 1a shows a plan view of a preferred embodiment of the invention comprising a shaped thin film magnetic structure **1** (also called magnetic cell), embedded in an immersion magnetic layer **2**. Where **1** is in contact with **2**, magnetic flux lines flow easily between them. Therefore the free pole energy associated with magnetisation perpendicular to the left and right edges of **1** is greatly reduced. This allows the magnetisation in **1**, represented by the arrow **10**, to remain uniformly aligned from end to end, including in the magnetisation **11** representing the end of the structure where free poles would tend to collect. That is, end domains of **1** are reduced and/or removed due to the magnetic contact with **2**. FIG. 1b shows a cross-sectional view of this same embodiment. The flux lines **11** flow in and out of **1** from **2** reducing the free pole energy and fringing fields of **1** at the perpendicular-to- magnetisation-direction ends.
It is important to note that according to the invention, the immersion layer 2 does not have a predetermined magnetisation.

Viewed another way, the end domains are removed from **1** at the expense of occurring in **2** (that is, creating an inhomogeneous magnetisation distribution in **2**, represented by the arrows **12**). This distribution can be the so-called flower state (as shown; a generic description given to a magnetic pattern where the magnetisation is fairly uniform but points towards the corners as you get close to them), or any other non-uniform distribution of magnetisation. The distribution will be determined from a combination of the characteristics of end and/or closure domains that would otherwise occur in **2** given its shape and the end and/or closure domains that would otherwise occur in **1** (due to the effect of flux flowing, and magneto static energy passing, between **1** and **2**). Under the correct circumstances (for example, for a soft or highly permeable magnetic material **2**), the magnetisation distribution in **2** will tend to arrange itself in order to increase spatial homogeneity of the demagnetising field in **1**. In this sense, the magneto static energy contained in the magnetisation distribution in **2** plays the same role as exchange energy in very small magnetic structures, leading to increased possibility of creating a single magnetic domain condition for **1**. The arrows **12** which are shown in the accompanying drawings always refer to an example of such a magnetisation distribution in **2**, never to a predetermined magnetisation direction.

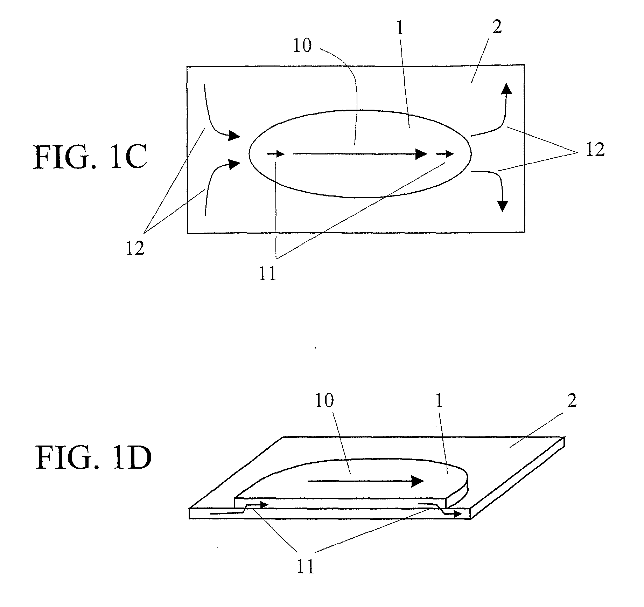

In another embodiment the shape of **1** is elliptical rather than rectangular (FIG. 1c). FIG. 1d shows a cut away 3D view of the embodiment shown in FIG. 1c.

The benefit of a single domain particle behaviour can be very large for magnetisation reversal devices. Stoner-Wohlfarth rotation is a result of single-domain behaviour and is desirable in switching in MRAM to lower the half-select threshold (J. M. Slaughter, R. W. Dave, M. DeHerrera, M. Durlam, B. N. Engel, J. Janesky, N. D. Rizzo, and S. Tehrani, "Fundamentals of MRAM Technology", Journal of Superconductivity: Incorporating Novel Magnetism, Vol. 15, No. 1, 19-25 (February 2002)). In precessional switching, single domain behaviour is also beneficial to switching properties.

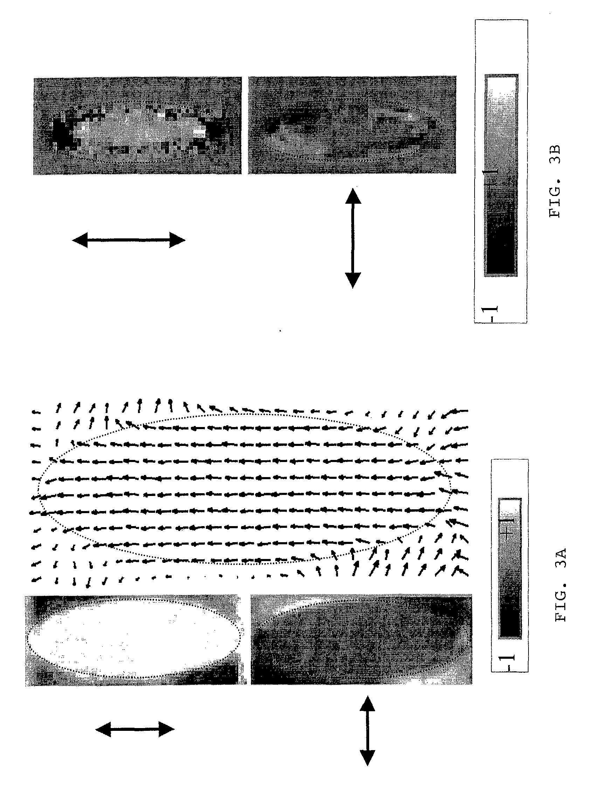

FIGS. 3a-3c are experimental data support figures for the embodiment depicted in Fig. 1c and Fig. 1d. for the desired behaviour brought about by the invention. FIG. 3a shows the magnetisation vector components at the top surface of **1** and **2**, of one experimentally realised embodiment, measured with the magneto-optical Kerr effect. In this case, **1** is a 20 micron by 7 micron ellipse shaped magnetic structure and **2** is a much larger film made out of the same material. The thickness of **1** is 16 nm and the thickness of **2** is about 5nm. In this case, the device was made by defining a lithographic pattern in photo resist for the shape of **1**, applying dry etching to remove the magnetic film, but only removing part of the magnetic film (the top 11nm) leaving an immersion layer of 5nm thickness. The dotted line denotes the edge of 1 and three representations of this device are shown. The top left representation is a gray-scale map of the vertical component of magnetisation, the bottom left a gray-scale map of the horizontal component of magnetisation and the right is a vector representation. The magnetisation state captured is the one at remanence after a magnetic field oriented orthogonal on the cell surface has been reduced from saturation to zero. The vector image shows the magnetisation being highly uniformly magnetised within the boundaries of **1**, right up to the edges (also confirmed by the homogeneous colours within the left images). The magnetisation in **2** is non-uniform. The arrows indicate a continuous flow of magnetisation vector direction between **1** and **2**, which is indicative of a continuous flow of flux between **1** and **2**. A very similar device was made according to prior art (that is, no material **2**) and is shown in FIG. 3b. This material is a 12 micron by 5 micron ellipse shaped structure, made of the same material as in 3a, of the same thickness as **1** in 3a of 16nm, and measured after a similar remanence process where a magnetic field oriented orthogonal on the cell surface is reduced from saturation to zero. The magnetisation is represented in the same gray-scale way as the first two representations of FIG. 3a. The gray colour outside the dotted line indicates no magnetisation in either direction, which is consistent with there being no magnetic material in this region. The colours inside of the dotted line vary as a function of position, indicating that end domains and nonuniformity of the magnetisation occurs within the structure.

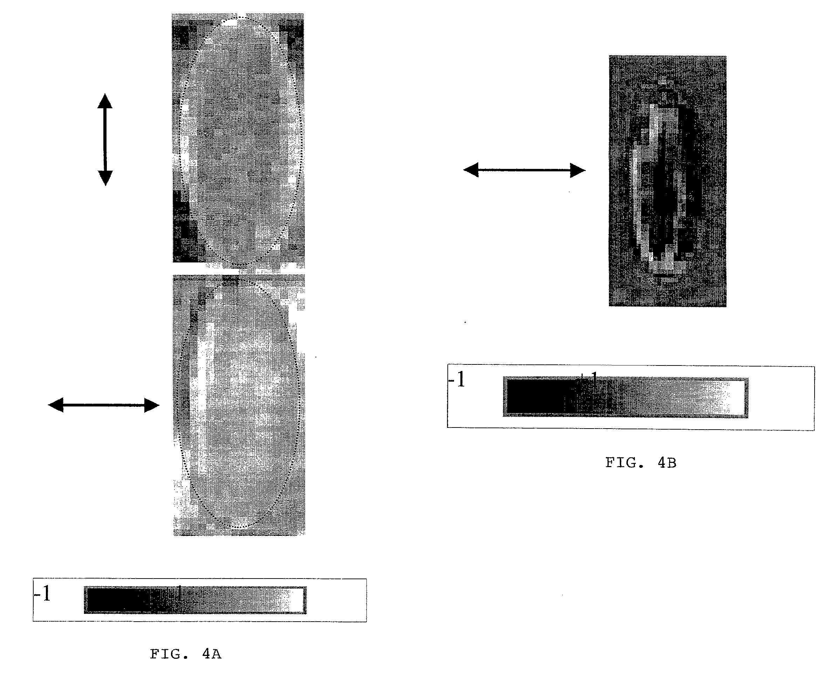

That single-domain behaviour is an advantage for magnetic switching applications is well known. FIG. 4a shows some experimental evidence of the maintenance of single domain uniformity in a precessional switching process in an experimentally realised embodiment of the invention, while FIG. 4b shows large nonuniformity in a similar experimental structure of prior art style (with no immersion layer). In FIG. 4a, the experimental embodiment of the invention from FIG. 3a is tested in high-speed operation and in FIG. 4b, the prior art (no immersion layer) device of FIG. 3b is tested in high-speed operation. Both samples start in their initial remnant states, which are shown in FIGS. 3a-b. A step field in the horizontal, transverse direction is applied in each case with a rise time of a few hundred picoseconds. The amplitude of the field is about 31 Oe for FIG. 4a and about 41 Oe for FIG. 4b. The images show response about 2 ns after field turn-on. For the immersion sample, the response is very spatially uniform within the mesa area of the ellipse. For the sample with no immersion, the response is definitely non-uniform. Thus, the invention pertains not only to the static properties of structure 1 but to the dynamic properties as well. Increased uniformity contributes to a more likely chance of coherent rotation and Stoner-Wohlfarth behaviour. Dynamic reorganisation of the magnetisation distribution in layer **2** can further act to keep the demagnetising field more uniform in **1** at instances throughout the duration of dynamic and nonequilibrium processes in **1**.

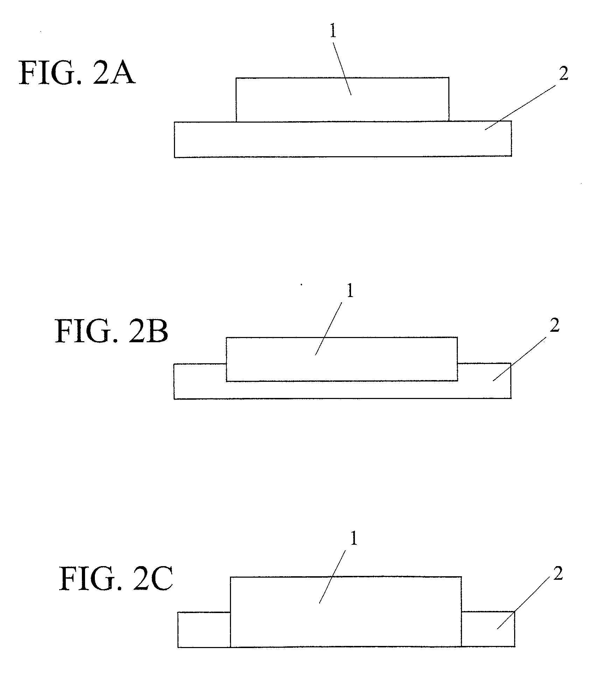

The shape of **1** can be any 2-dimensional shape. Likewise, the shape of **2** can be any 2-dimensional shape. **1** and **2** can be the same material or a different material. If **1** and **2** are different materials, **1** can be touching, can be partially embedded, or can be fully embedded in **2** as shown in FIGS. 2a-2c.

In the preferred embodiments, the thickness of **1** is greater than that of **2** though in other embodiments the thickness of **2** can be less than, can be equal to, or can be greater than **1**. In the preferred embodiments, the size of **2** is greater than the size of **1**, but in other embodiments at least one of the in-plane dimensions of **2** can be the same size or can be smaller than that of **1**. Similarly, in yet another embodiment, both in-plane dimensions of **2** can be smaller than those of **1**. In the preferred embodiment, **1** is placed in the geometric centre of **2**, however, in another embodiment **2** can be acentric with respect to **1** as in FIG. 5a. In still another, **2** can occupy a portion of the plan area that 1 occupies. An example is shown in FIG. 5b. Further, in yet other embodiments, **2** can be a discontinuous layer, for example, 2 separate pieces as in FIG. 5c, can be at a single position as in FIG. 5d, or can be at several locations as in FIG. 5e.

The invention can fully remove inhomogeneity from the cell **1** or can only partially remove it. The amount of inhomogeneity can also be controlled by the shape and geometry of both **1** and **2**. The shape and/or configurationally induced anisotropy of the immersion layer **2**, that is, the magneto static configuration of **2**, can be at any angle compared with the shape and/or configurationally induced anisotropy of the structure **1**. Further, any other anisotropies in **2**, such as sputter-field induced, crystalline induced, or strain induced can have their dominant portions or symmetry directions at any angle with respect to any other anisotropies (sputter, crystalline, strain, or other) existing in **1**. The inhomogeneous magnetisation distribution in **2** can be any distribution whatsoever that contributes magnetostatically to increased homogeneity in cell **1** (the limiting embodiment being a distribution that perfectly induces a single domain in cell **1**).

An alternative embodiment of the invention is shown in FIG. 5'. In this embodiment, the magnetic structure **1** is not touching the immersion layer **2,** but is separated by a spacer layer of nonmagnetic material, either conducting or insulating. Magnetostatically, **1** is still connected with **2** and the magnetisation of **2** can still arrange itself to increase the uniformity of the demagnetisation fields felt spatially throughout **1** and flux can still flow between **1** and **2**. In this embodiment, an additional advantage is also foreseen. The improved uniformity of magnetisation in **1** offered by the invention can be combined with a desired choice of the exchange coupling through the spacer layer [Ref. Oscillatory coupling - Parkin] for increased control of the magnetic behavioural properties of **1**.

The devices disclosed in the preferred embodiments can be made by any standard microlithographic technique. In the preferred embodiment, **1** and **2** are created out of the same thin film by subtractive etch patterning, as shown in the sequence in FIGS. 6a-c. Photo resist or some other pattern transfer material **5** is located on top of a bulk magnetic film **3**, on top of an existing substrate or processed substrate **4**. The photo resist is in the pattern that will define area **1**. The etch removal of **3** is only partially completed leaving a thinner area **2** and a defined thicker area **1**. Alternatively, the film material of area **1** can be partially removed leaving area **1** as the thinner area. The subtractive etching technique can be, but is not limited to, dry ion etching, wet chemical etching, reactive ion etching. Further, e.g. but not only, the technique of liftoff can be used to form the patterned layers.

An alternative embodiment for fabrication is defined by an inversion process as in FIGS. 7a-c. A trench is etched in a substrate **4**; a thick magnetic film **3** is put on top of the now topographic substrate. The film can be planarized by chemical mechanical polish or some other planarization method, to define an inverted mesa **1** in immersion film **2**.

Instead of an inverted mesa, a regular mesa can be formed and the invention deposited on top and planarized, giving a thinner magnetic structure **1** than immersion layer **2**.

In FIG. 7d, an alternative process is shown in which no planarization step is needed. The film **3** of appropriate final thickness is deposited on top of the substrate **4**. The trench in **4** defines the boundaries of **1** and **2**. Sections **1** and **2** can be the same thickness. Alternatively, a partial planarization can be done such that **2** is thinner than **1**, but not necessarily level at either surface as in FIG. 7e. Alternatively yet again, the inverted mesa can be a regular, non-inverted mesa.

FIGS. 8a-d show alternative embodiments of the invention in cross-section where the film surfaces of **1** and **2** do not have to be level with each other. Structure **1** can be thicker than **2** and extend beyond the top surface and below the bottom surface, it can be thicker and extend beyond only one of the two surfaces of **2**, it can be thinner than **2** but still extend beyond one of its surfaces, or **1** can be thinner than **2** with **2** extending beyond at both surfaces.

Similarly, the manufacturing processes shown in FIG. 7 can use two different materials for **1** and **2**. In FIG. 7c, the polishing can entirely remove material **2** such that the substrate **4** is exposed. Then, a different material **2** can be deposited, as seen in FIG. 9a. Either of **1** or **2** can be a multilayer of magnetic material or a multilayer of a combination of magnetic and nonmagnetic material. FIG. 9b is an example of an embodiment with a multilayer magnetic material for **2**, wherein the polishing removes most of the original material, **1** is made of the original material, and **2** consists of a double layer of material.

The invention can be incorporated into any device such as, but not only, a magnetic sensor, a magnetic recording head sensor, or a magnetic random access memory. The structure **1** can be the free (sense) layer of a multilayer magnetoresistive stack or part of the free (sense) layer of said stack or part of another magnetic layer of a multilayer stack (such as the pinned layer).

The benefits of including any of the embodiments of the invention in a device structure are many. Increased uniformity of the magnetisation of a magnetic structure (like **1**) as a free layer can allow maximum signal to be obtained via a magnetoresistive effect of **1** with a reference layer in a GMR or TMR stack. Further, increased uniformity also contributes to better defined dynamic behaviour of a free layer. Further still, a free layer coupled to an immersion layer can have smaller magneto static coupling effects with the other layers of the magnetoresistive stack, thus, the invention can lead to reduction in the offset of the hysteresis of such devices.

Yet further still, coupling a device free layer **1** to an immersion layer **2** allows beneficial alterations in the dimension of **1**. Usually, in order to keep a free layer behaving with more single domain-like behaviour, the thickness has to be reduced and/or the lateral dimensions have to be increased. This is because the demagnetisation fields have more effect for thicker and smaller lateral dimension structures (with the exception that, in the limit of very small lateral dimensions, exchange interaction dominates magneto static interactions). With an immersion layer **2** coupled to a free layer **1**, the thickness of **1** can be increased and/or its lateral dimensions decreased while maintaining the same uniformity of demagnetisation field that would occur in the thinner or larger device that was not coupled to an immersion layer. The benefits of having a smaller device are obvious (increased packing density in MRAM, for instance). The benefit of having a thicker free layer is increased thermal stability due to the increased magnetic volume. Further, contact with the immersion layer also effectively adds additional volume to the magnetic structure **1** (and, correspondingly, more thermal stability).

FIGS. 10a-c show an embodiment of the invention in a magnetic random access memory (MRAM) cell. **1** now refers to a magnetoresistive MRAM multilayer element such as a magnetic tunnel junction stack. In one embodiment, the cell **1** can be comprised of a free, soft magnetic layer or soft magnetic double layer or multilayer (whose magnetisation homogeneity is increased by the invention) adjacent to a nonmagnetic tunnel barrier, further adjacent to a pinned magnetic layer (which can be pinned by an antiferromagnet, an artificial antiferromagnet, or some other means). In another embodiment the cell can be a GMR based cell where the tunnel barrier is replaced by a nonmagnetic conductor such as Cu.

The immersion layer **2** is made nominally the same width as the current carrying word or bit line **6**. It can be made in the same lithography step having the same length and width dimensions as **6** or it can have a different length and it can have a different width. The long dimension of current wire **6** can be either perpendicular or parallel to the easy axis of the MRAM cell, or at some other angle such as 45 degrees. Further, the MRAM element **1** can be of the same width as the conductor, or smaller or larger, and of any shape. The shape and/or configurationally induced anisotropy of the immersion layer **2**, that is, the magneto static configuration of **2**, can be at any angle compared with the shape and/or configurationally induced anisotropy of the cell **1**. Further, any other anisotropies in **2**, such as sputter-field induced, crystalline induced, or strain induced can have their dominant portions or symmetry directions at any angle with respect to any other anisotropies (sputter, crystalline, strain, or other) existing in **1**. The inhomogeneous magnetisation distribution **12** in **2** can be any distribution whatsoever that contributes magnetostatically to increased homogeneity of magnetisation **10** in cell **1**, particularly at the cell ends **11** (the limiting embodiment being a distribution that perfectly induces a single domain in cell **1**).

Another embodiment for an MRAM device has the immersion layer manufactured with the top current line as shown in cross-section in FIG. 11a and side view in FIG. 11b. Again, **2** can be the same or a different lateral size to the current line **6**, it can exist all along the length of **6** or stop between each cell of the array, and/or it can be made in a single lithography step with **6**. The MRAM cell 1 can be smaller, larger, or the same width as **6**.

An embodiment of the array for such an MRAM device is shown in plan view in FIG. 12a. Here, only a few devices on a single line of the array are shown. The immersion layer can be associated with (that is, positioned next to and possibly, partially, fabricated in the same masking step) the bottom current line or the top current line (which is orthogonal to the bottom current line). Three cells **1** are shown adjacent in a line with their immersion layers **2** also shown. The current line that the immersion layer is not associated with is omitted in this view. In this embodiment, the immersion layers are disconnected. The third cell to the right points in opposite direction to the other two. The edges of the layers **2** define pinning positions to minimise cross talk between neighbouring cells.

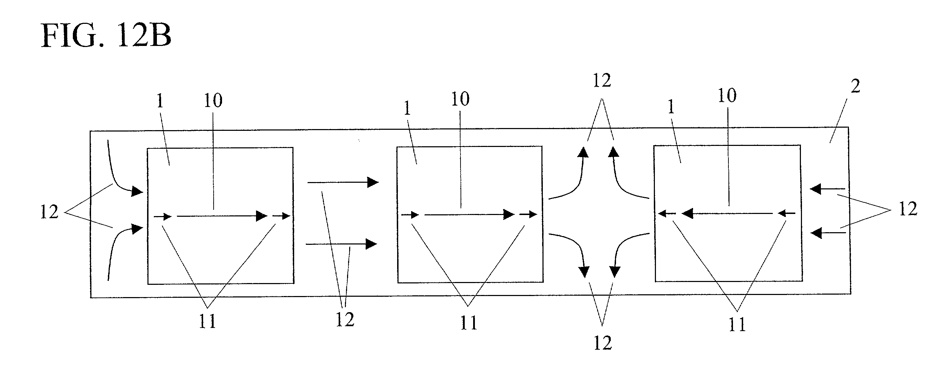

Another embodiment of such an MRAM device array is shown in plan view in FIG. 12b. Now, the immersion layer **2** is continuous and can be made in the same lithographic step as the current line. The area **2** between the second and third cell has extra magneto static energy due to the difference in magnetisation direction between the second and third cell.

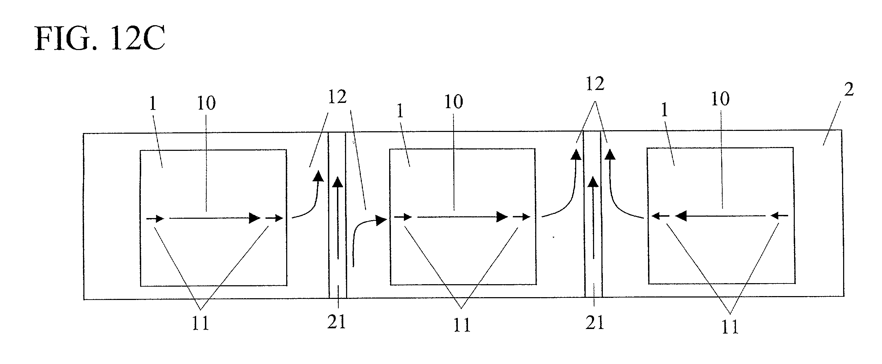

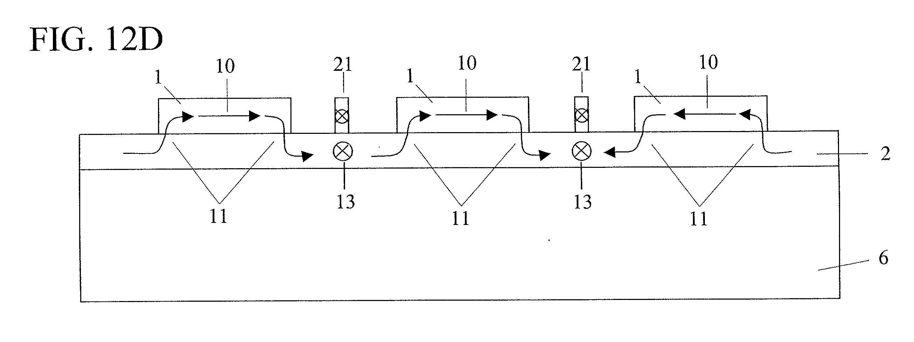

Another embodiment of such an MRAM device array is shown in plan view in FIG. 12c and side view in FIG. 12d. Magnetic cells **1** are again adjacent to a continuous immersion layer **2**. Now, an additional magnetic structure **21** is added that is also magnetostatically coupled to immersion layer **2**. In this case, the shape of **21** is such that the magnetisation in it **13** is directed essentially perpendicular to the long dimension of the immersion layer **2** (but still in plane). It thus acts as a pinning position to minimise magneto static cross talk between neighbouring cells and to pin any dynamic motions of the magnetisation of the immersion layer **2**. **21** can be made from the same magnetic layer as **1** with a single lithographic step, though it can also be made in different steps and with different layers.

An embodiment of the invention for application to a magnetic field sensor is shown in fig. 13. The invention is generically applicable to magnetic field sensor devices. In this specific embodiment, the magnetic cells 1 of the invention are present as two GMR sensing layers 1, which are part of the usual Wheatstone bridge design (not shown) with thick, soft magnetic flux guides 3 guiding the flux into the sensor area to increase sensitivity. In an embodiment of the invention, a soft magnetic immersion layer 2 is added to either the flux guides 3, or the sensors 1, or both. The layer 2 can be contacting only 1 or only 3, or separate layers can be separately contacting 1 and 3, or a single immersion layer 2 can contact both the flux guides and the sensors. In an embodiment, layer 2 can have an induced easy axis parallel to the flux guides parallel to the magnetisation arrows shown. The sensors can have an induced easy axis perpendicular to the arrows shown, but a shape axis that dominates forcing the magnetisation into the hard direction. The role of the immersion layer 2 has (at least) three benefits. (1) Increases uniformity and stability of the sensor with the reduction of free poles in the soft layer of the sensor. (2) The layer 2 can increase the sensitivity of the immersion layer. This can be done by effectively reducing the shape anisotropy that forces the magnetisation to lie in the direction shown in zero field. Thus, smaller fields cause larger shifts in the magnetisation giving increased sensitivity. If layer 2 is joined with both 3 and 1 it can also channel the flux guiding directly into the sensor, increasing its effect. Of course, an increased uniformity of the magnetisation in the sensor can also contribute to increased signal since the magnetoresistance can give more signal probing the whole device rather than a portion of the device (would-be end domains) contributing only partial signal. (3) The uniformity and stability can benefit long-term reliability and stability of the sensors.

The immersion layer can be applied to the hard layer of an MR (Magneto Resistance) device, not just the soft layer. The immersion layer can improve the long-term stability of the hard layer, making it less likely to demagnetise over time (a problem of demagnetising over time of the hard layer was cited in ('oscillatory decay of magnetisation induced by domain-wall stray fields', Thomas L., Luning J., Scholl A., Nolthing F., Anders S., Stohr J., Parkin SSP, Physical-Review-Letters, vol.84, no.15; 10 April 2000; p.3462-5). The embodiment of the invention can thus contain a soft cell and soft immersion layer, or a hard cell and soft immersion layer or a soft or hard cell and hard immersion layer.

Another embodiment of the present invention is depicted in Fig. 14; an array of magnetic cells 1 immersed in a continuous magnetic layer 2. For some applications an array of magnetic cells can be desirable. These cells can be multilayer MR device stacks. The immersion layer makes each cell more single domain like and its behaviour closer to that of a bulk thin film. Thus, an array can be used where a bulk film property would be desired but array properties necessary (one example is MRAM). In another embodiment, the array can act together as a single sensor, covering a large area, but with the ability to engineer the behaviour of the sensor more so than can be done with a bulk magnetic film. This extra ability comes from the extra engineering that can be done to the substructures such as size and shape. The embodiment in fig. 14 can represent a locally operating sensor matrix device with each cell interrogated separately giving a spatial readout of the local magnetic field.

## Claims

1. A magnetic device comprising:
• A magnetic cell (1) of a first magnetic material of a first permeability; and
• An immersion layer (2) of a second magnetic material of a second permeability, said immersion layer providing a magnetic flux closure path for the magnetisation field of said magnetic cell,
wherein said immersion layer does not have a predetermined magnetisation direction.

2. The magnetic device of claim 1 wherein said first magnetic material has a higher permeability than said second magnetic material.

3. The magnetic device of claim 1 wherein said first magnetic material has a lower permeability than said second magnetic material.

4. The magnetic device of claim 1 wherein said first magnetic material and said second magnetic material are the same.

5. The magnetic device of claim 1 to 4 wherein said magnetic cell (1) is in direct contact with said immersion layer (2).

6. The magnetic device of claim 1 to 5 wherein said immersion layer (2) is discontinuous and/or comprising different separated subparts.

7. The magnetic device of claim 1 to 6 wherein said magnetic cell (1) is attached on top of said immersion layer (2).

8. The magnetic device of claim 1 to 6 wherein the edges of said magnetic cell (1) are in direct contact with said immersion layer (2).

9. The magnetic device of claim 8 wherein the upper surface of said magnetic cell (1) extends above the level of the upper surface of said immersion layer(2).

10. The magnetic device of claim 8 wherein the upper surface of said magnetic cell (1) extends below the upper surface of said immersion layer (2) or is at the same level with the upper surface of said immersion layer (2).

11. The magnetic device of claim 1 to 8 wherein said magnetic cell (1) is at least partially embedded in said immersion layer (2).

12. The magnetic device of claim 1 to 7, comprising between said magnetic cell (1) and said immersion layer (2) a spacer layer (7) comprising a non magnetic material.

13. The magnetic device of claim 12, wherein said spacer layer (7) consists of a conductor material.

14. The magnetic device of claim 12, wherein said spacer layer (7) consists of an insulator material.

15. The magnetic device of claim 1 to 14 wherein the magnetisation of said magnetic cell (1) forms a single magnetic domain.

16. The magnetic device of claim 1 to 15 wherein said magnetic cell (1) has a rectangular shape.

17. The magnetic device of claim 1 to 15 wherein said magnetic cell (1) has an elliptical shape.

18. The magnetic device of claim 1 to 17 wherein the thickness of said magnetic cell (1) is larger than the thickness of said immersion layer (2).

19. The magnetic device of claim 1 to 17 wherein the thickness of said magnetic cell (1) is smaller than the thickness of said immersion layer (2).

20. The magnetic device of claim 1 to 17 wherein the thickness of said magnetic cell (1) is equal to the thickness of said immersion layer (2).

21. The magnetic device of claim 1 to 20 wherein said magnetic cell (1) is smaller than said immersion layer (2).

22. The magnetic device of claim 1 to 20 wherein at least one of the in-plane dimensions of said immersion layer (2) is essentially smaller or of the same size than those of said magnetic cell (1).

23. The magnetic device of claim 1 to 20 wherein both in-plane dimensions of said immersion layer (2) are essentially smaller or of the same size than those of said magnetic cell (1).

24. A method for producing a magnetic device, **characterised in that** it comprises the steps of
• Providing a base layer (4).
• Depositing a first layer (3) consisting of essentially a magnetic material on said base layer.
• Defining a cell area of said first layer corresponding to the required magnetic cell structure.
• Performing a subtractive etch patterning step on said first layer, except on said cell area, for only part of the thickness of said first layer (3).

25. A method for producing a magnetic device, comprising a magnetic cell structure, **characterised in that** it comprises the steps of
• Providing a base layer (4).
• depositing a first layer consisting of essentially a first magnetic material on said base layer.
• providing a second layer consisting of essentially a second magnetic material,
• Defining a cell area of said second layer corresponding to the required magnetic cell structure.
• Performing a subtractive etch patterning step on said second layer, except on said cell area, for the full thickness of said second layer.

26. Method as recited in claim 25, wherein between said deposition step of said first layer and said deposition step of said second layer an extra step is performed of depositing a sacrificial layer (7) consisting essentially of a non magnetic material, and wherein said substractive etch patterning step is performed such that at least part of said sacrificial layer is removed.

27. Method for the production of a magnetic device comprising a magnetic cell structure, **characterised in that** it comprises the steps of:
• Providing a base layer
• Etching one or more trenches in said base layer, each trench corresponding to said magnetic cell structure, said base layer having thus a non-flat topology.
• Depositing a first layer consisting essentially of magnetic material on said base layer with said non-flat topology.

28. Method of claim 27 comprising an additional step of planarization of said first layer.

29. Method of claim 28 further comprising an additional step of depositing a second layer consisting essentially of a second magnetic material on top of the planarized surface.

30. Method according to claim 28 wherein said planarization of said first layer is continued until said base layer is reached, further comprising the step of depositing a second layer consisting essentially of a second magnetic material on top of the planarized surface.

31. Method of claim 27 to 30, wherein said trenches have an elliptical shape in the in-plane dimension.

32. Method of claim 27 to 30, wherein said trenches have a rectangular shape in the in-plane dimension.

33. Method as recited in claims 24 to 30, wherein said base layer is a substrate or a processed substrate.

34. A magnetic memory device comprising:
• a bit line (6) essentially consisting of a conductor material
• a magnetic device, as recited in claim 1 to 23, attached on top of said bit line.

35. The magnetic memory device of claim 34 wherein the immersion layer (2) of said magnetic device has the same or a smaller width then said bit line (6).

36. The magnetic memory device according to claim 34 to 35 wherein said immersion layer (2) has the same or a smaller length then said bit line (6).

37. The magnetic memory device of claim 34 to 36, wherein the easy axis of said magnetic device is perpendicular to the long dimension of said bit line (6).

38. The magnetic memory device of claim 34 to 36, wherein the easy axis of said magnetic device is orthogonal to the long dimension of said bit line (6).

39. The magnetic memory device of claim 34 to 36, wherein the easy axis of said magnetic device is at an angle to the long dimension of said bit line.

40. A magnetic memory array device comprising:
• A bit line (6) essentially consisting of a conductor material.
• At least 2 magnetic devices as recited in claim 1 to 23, wherein said magnetic devices are attached next to each other on said bit line (6) and wherein said magnetic devices are not touching.

41. The magnetic memory array device as recited in claim 40, wherein all of said magnetic devices share the same immersion layer (2).

42. The magnetic memory array device according to claim 40 to 41 wherein the magnetisation direction of all of said magnetic devices is parallel with the long dimension of said bit line (6).

43. The magnetic memory array device according to claim 41 to 42 further comprising between each pair of said magnetic devices an additional magnetic structure (21), wherein said additional magnetic structure consists essentially of a magnetic material and wherein said additional magnetic structure has a shape such that the magnetisation in it is essentially perpendicular to the long direction of said bit line (6) and essentially parallel to the width direction of said bit line.

44. A magnetic field sensor device comprising:
• A sensor area defined by a sensor layer (1)
• A soft magnetic flux guide (20), consisting essentially of a magnetic material with a low permeability, for guiding flux lines to said sensor area, wherein said soft magnetic flux guide is adjacent to said sensor area.
• A magnetic immersion layer (2) consisting essentially of a material of a low permeability.

45. A magnetic field sensor device as recited in claim 44 wherein said magnetic immersion layer (2) contacts both said sensor layer (1) and said soft magnetic flux guide (20).

46. A magnetic field sensor device as recited in claim 44 wherein said magnetic immersion layer (2) contacts said sensor layer (1).

47. A magnetic field sensor device as recited in claim 44 wherein said magnetic immersion layer (2) contacts said soft magnetic flux guide (20).

48. A magnetic field sensor device according to claim 44 to 48 wherein said sensor area consists of 2 GMR sensor layers in line and wherein said soft magnetic flux guide extends in 2 areas, said 2 areas being located on either side of said 2 GMR sensor layers in line.

49. An array of magnetic cells, wherein said magnetic cells (1) are immersed in a same immersion layer (2) and wherein said magnetic cells are positioned on a regular lattice configuration.
